# EUROPEAN PATENT APPLICATION

(11) **EP 4 528 935 A1**
(43) Date of publication of application: **26.03.2025**
(21) Application number: 23199164.7
(22) Date of filing: 22.09.2023
(51) Int. Cl.: H01R 12/70, H01R 13/518, H01R 13/6594, H01R 13/6587, H01R 13/516

(54) **CONNECTOR FRAME UNIT AND CONNECTOR FRAME STRIP FOR CHICKLETS**

(71) Applicant: TE Connectivity Belgium B.V., 8020 Oostkamp (BE)
(72) Inventor: LIEBAERT, Koen, 8020 Oostkamp (BE); DEVOS, Peter, 8020 Oostkamp (BE); DEGRYSE, Ronny, 8020 Oostkamp (BE); BAERTSOEN, Peter, 8020 Oostkamp (BE)
(74) Representative: Grünecker Patent- und Rechtsanwälte PartG mbB

(57) **Abstract**

A frame unit (710) that interfaces a chicklet and a printed circuit board is described. The frame unit includes at least one fixing member (750a, 755a) that fixes the frame unit to a PCB, and an opening (760) that accepts and holds a chicklet therein. The frame unit accepts a chicklet such that electrical connections are formed between the chicklet and the PCB beneath the frame unit. The edge (770) of the opening (760) can flex and/or make conductive electrical contact with the chicklet, and fixing member(s) (755a, 755b, 755c, 755d) can make electrical contact to the PCB. A frame strip is also described, which may include multiple frame units (710) which can be separated from the frame strip. Frame units and frame strips can facilitate chicklet placement within strict tolerances.

## Description

The present disclosure relates to electrical connectors, and the assembly thereof. For example, connection assemblies for chicklets and printed circuit boards (PCBs) are described herein.

Electrical connectors between different electrical components are used in many devices. Herein is disclosed a frame unit for interfacing a chicklet and a PCB, and a frame strip that includes multiple frame units. A frame strip can be used to interface a variable number of chicklets to one or more PCBs.

Chicklets can be used for making electrical connections to PCBs, such as between PCBs, and/or between a surface mounted device (SMD) and a PCB. Connection modules, like chicklets, have tolerances for making connections to PCBs. Chicklets, which have a rigid housing, such as a rigid metal housing for reducing electromagnetic interference (EMI), have stricter tolerances than more flexible connectors, such as those with a softer housing. Making robust physical and/or electrical contact between a chicklet and a PCB can be difficult, and the assembly process may be vulnerable to stress induced breakage such as when tolerances are not met. When electrical and physical contact is made between a chicklet and PCB, there can be problems with mechanical strain of joints, connections, and other components, which may lead to reduced component lifetime.

Herein are disclosed frame units which can aid in meeting tolerance requirements of the assembly of devices that utilize chicklets and PCBs. The frame units described herein can be used singly or multiply to hold one or more chicklets to a PCB.

Furthermore, the ability to rapidly and flexibly make electrical devices of variable complexity and/or functionalization is an important manufacturing concern. A manufacturing process that can flexibly adapt to generate surface mounted devices of variable types is desirable. Herein are disclosed frame strips, of multiple connected frame units, which may be used to attach one or more chicklets to one or more PCBs. In manufacturing, for example, it is desirable to be able to rapidly place variable numbers of components, such as chicklets and PCBs, to form devices of variable complexity.

### Summary

Herein are described frame strips, which include a plurality of connected frame units. The frame units of the frame strips can be as described herein.

A frame unit configured to interface a chicklet and a PCB is disclosed, including at least one fixing member configured to fix the frame unit to the PCB; an opening configured to accept a chicklet, and configured such that electrical connections are formed between the chicklet and the PCB beneath the frame unit. The opening is configured to hold therein the chicklet. This configuration can serve as an intermediary between the chicklet and the PCB so that some of the mechanical strain of attachment between the chicklet and the PCB can be transferred to the frame unit. Alternatively/additionally, the opening can serve to guide the chicklet to the proper position, e.g. reducing assembly errors.

Each of the above described frame unit and frame strip may be further improved by one or more optional features, presented in the following embodiments. Each of the following features is advantageous on its own and may be combined independently with any other optional feature(s)

The frame unit, according to any embodiment described herein, can make conductive electrical contact with the chicklet, e.g. at least part of an edge of the opening can make conductive electrical contact with the chicklet. By making electrical contact, there can be better electromagnetic shielding. For example, good electrical contact can shield sensitive high frequency signals passing through the chicklet. Alternatively/additionally, ground loops can be avoided.

The opening, of any frame unit described herein, can align with at least one PCB contact for electrical coupling of the PCB contact(s) and at least one electrical connector of the chicklet. Alternatively/additionally, the opening is configured such that electrical connections are formed between the electrical connectors and the PCB beneath the opening of the frame unit, e.g. directly beneath the opening. The position of the opening can aid in simplifying the assembly process, e.g. with the contacts of the PCB being (possibly directly) reachable by the chicklet when it is inserted into the opening. The frame unit can aid in guiding the chicklet to the proper position, which may reduce assembly errors. Alternatively/additionally, the close contact of the chicklet to the PCB (possibly directly) beneath the opening can aid in shielding from electromagnetic interference (EMI).

At least part of an edge of the opening can possibly flex for holding the chicklet. A flexible edge can reduce mechanical strain being transferred to the chicklet. Alternatively/additionally, a flexible edge can provide a variable contact force for holding the chicklet, e.g. a contact force that tends to hold the chicklet in a desired position, e.g. over the PCB contact(s). Alternatively/additionally, as explained above, at least part of the edge can electromagnetically shield a signal which passes through the chicklet and/or the at least one PCB contact. It is desirable to provide multiple capabilities, e.g. of providing electrical contact, EMI shielding, and/or mechanical holding of the chicklet/PCB assembly.

The frame unit can include at least one contact spring at the edge of the opening for holding the chicklet and/or for making electrical contact to the chicklet. A contact spring can effectively hold the chicklet, e.g. for alignment between the PCB contact(s) and chicklet terminal(s).

The frame unit can include at least one shielding element that extends above the bottom of the edge of the opening. It can be desirable for additional EMI shielding, especially near the junction of the frame unit and the chicklet, e.g. to avoid signal crosstalk between conductors of the PCB and/or chicklet. The at least one contact spring can extend above the at least one shielding element (790). A lengthy contact spring may aid in more easily tuning the contact force, e.g. since the stiffness of the contact spring can be tuned with length, e.g. in order to provide a contact force within acceptable tolerances (e.g. above a minimum for providing adequate fixing force and below a maximum to avoid breakage). There can be multiple contact springs and shielding elements, and the contact springs and shielding elements can alternate positions along the edge.

Multiple contact springs can aid in distributing the contact force along the length of the opening an/d or the length of the chicklet. High local stress can be avoided, in the frame unit and/or chicklet. Multiple shielding elements can aid in providing adequate shielding spatially where necessary, e.g. to avoid EMI. Having alternating shield elements and contact springs can allow balancing the effects of each, e.g. distributing the contact force more evenly while providing for good spatial protection from EMI.

The opening can have a short axis and a long axis, and the contact springs can be along the long axis. Having the contact springs along the long axis can provide for an even distribution of contact forces along a longer axis, e.g. for more even distribution of stress. Alternatively/additionally, having the contact forces distributed can more reliably fix the chicklet to the proper location, e.g. for alignment with the PCB. Assembly errors can be reduced.

The fixing member(s), according to any embodiment described herein, can include one or more standoffs which extends below the frame unit. The standoff(s) can be solderable and/or weldable to form connections, such as electrical connections to the PCB. Having connections between the standoffs at the bottom of the frame unit and the PCB can aid in meeting strict mechanical tolerances (e.g. positioning of the frame opening relative to the PCB) and/or provide for more robust electrical connections between the frame unit and the PCB (e.g. for reducing ground loops and/or EMI). The standoffs can provide an even distance between the bottom of the frame unit and the PCB. This can aid in alignment and positioning of the chicklet relative to the PCB. Strict positional tolerances are more easily met and/or fewer assembly errors are made.

Any fixing member(s) described herein can include a guiding element extending below the frame unit. The guiding unit can mate with a hole of the PCB. The guiding element can aid in correctly positioning the frame unit to the PCB. Optionally, the guiding element includes at least one chamfered edge configured to make contact with the hole of the PCB for fixing the frame unit to the PCB. The guiding element can aid in holding the frame unit to the PCB.

The material of the frame unit(s) and frame strips described herein may include a solderable and/or weldable material. The material may aid in providing electromechanical connection to the PCB. The material can include at least one of beryllium copper, a tin coated metal such as tin coated copper, a tin coated stainless steel, or a tin coated copper alloy such as a tin coated copper 10 alloy. Beryllium copper can have desirable elastic properties, such as for flexing to hold the chicklet. A tin coating can aid in providing a weldable/solderable surface. Copper is also desirable for its low resistivity and/or heat conductive properties, which can reduce undesirable heating.

The frame strips described herein can include a groove between two adjoining frame units. The groove allows the separation of the two adjoining frame units. It is desirable to have frame strip that allows for separation of individual or groups of adjoined frame units, e.g. for flexible manufacturing of devices of variable numbers of chicklet connections.

The frame strips described herein can include a first rail and a second rail which are at opposite edges of the respective openings of the frame units. A plurality of frame members connect the first and second rails, the frame members being along a long axis of the respective openings. The frame members can include the edges of the openings. The rails can be along the short axis of the openings, and allow for the connection of multiple frame units, side by side, along the length of the rails of the frame strip. The openings of adjacent frame units can be separated by the frame members. The rails and frame members can provide stiffness and/or continuity to the frame strip.

The frame strip(s) herein have fixing member(s) which extends below at least one of the first and second rails or the frame members. Contact spring(s) and/or shielding element(s) extend above the frame members. Having the contact spring(s) and/or shielding element(s) extend upward on the opposite side of the frame strip to the fixing member(s) allows for the possibility of a short distance between the PCB and the frame strip and/or chicklet. This can aid in meeting the positional tolerances of connecting the chicklet to the PCB and/or can aid in reducing EMI.

Herein is disclosed a connection assembly including a PCB, at least one chicklet electrically connected to at least one PCB contact of the PCB and held by at least one respective frame unit. The frame units described herein can aid in meeting tolerance requirements of the attachment of chicklets to PCBs, for example.

In the following, explanations and examples are given with reference to drawings. Embodiments are described in such a way that features of one embodiment can be combined with other embodiments. A given feature which is described in one embodiment but not explicitly mentioned in another embodiment, for example, can be incorporated into the embodiments which do not explicitly mention the given feature. Furthermore, the description herein mentions optional features, either explicitly or implicitly, which may be omitted from embodiments, such as if the technical effect of the optional feature is not essential for a particular application.

### Brief Description of the Figures

Fig. 1 shows a frame strip according to an embodiment;
Fig. 2 shows a frame strip, chicklets, and PCB, according to an embodiment;
Fig. 3 shows a frame strip, chicklets, and PCB, according to an embodiment;
Fig. 4 shows a frame strip and PCB, according to an embodiment;
Fig. 5 shows a frame strip and PCB, according to an embodiment;
Fig. 6 shows a schematic of a portion of a PCB, according to an embodiment;
Fig. 7 shows a frame unit, according to an embodiment;
Fig. 8 shows a portion of a frame strip on a PCB, according to an embodiment;
Fig. 9 shows a portion of a frame strip holding a chicklet on a PCB, according to an embodiment;
Fig. 10 shows a portion of an edge of a frame unit, according to an embodiment;
Fig. 11 shows a portion of an edge of a frame unit, according to an embodiment;
Fig. 12 shows a guiding element, according to an embodiment;
Fig. 13 shows a portion of a frame strip, according to an embodiment;
Fig. 14 shows a chicklet, according to an embodiment;
Fig. 15 shows a connection assembly, according to an embodiment;
Fig. 16 shows a connection assembly, according to an embodiment; and
Fig. 17 shows a fame strip, according to an embodiment.

### Detailed Description

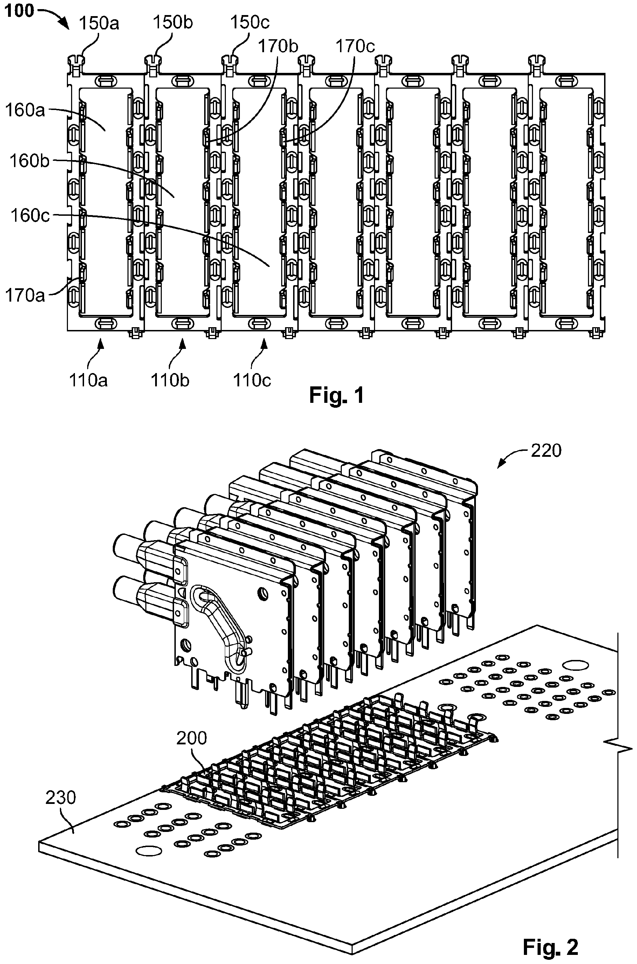

Fig. 1 shows a frame strip, according to an embodiment. A frame strip 100 can include one or more frame units 110a, 110b, 110c which each includes respective openings 160a, 160b, 160c. The frame strip 100 can include fixing member(s) 150a, 150b, 150c which can attach the frame strip 100, or at least one frame unit thereof 110a, to a PCB.

Fig. 2 shows a frame strip 200 attached to a PCB 230, according to an embodiment. Chicklets 220 are shown in Fig. 2 to schematically illustrate the alignment of the chicklets to the frame strip 200 such as during assembly. Each of the openings 160a, 160b, 160c of the frame strip 200 can hold a chicklet 220 therein, and are sized appropriately to allow insertion and/or holding of a chicklet.

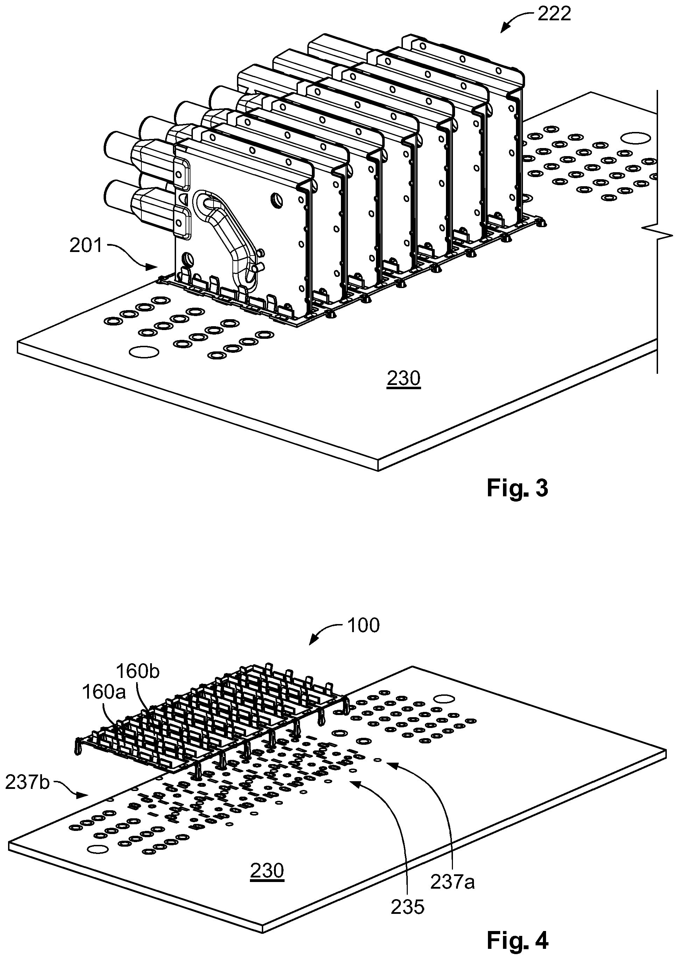

Fig. 3 shows an assembled frame strip, chicklets, and PCB, according to an embodiment. The frame strip 201, attached to the PCB 230, can allow the attachment of one or more chicklets 222, such that each chicklet 222 is accepted in an opening 160a, 160b, 160c of the frame strip 201. Electrical connections are formed between the chicklet(s) 222 and the PCB beneath each of the frame units 110 of the frame strip 201. The electrical connections can be formed directly between each chicklet 222 and the respective portion of the PCB beneath the respective frame unit 110a, 110b, 110c. The electrical connections formed between each of the chicklets and the PCB can be directly beneath the respective openings 160a, 160b, 160c of the respective frame units 110. Each chicklet can form one or more electrical connection to the PCB. The openings 160a, 160b, 160c are in a plane parallel to the PCB 230.

Fig. 4 shows an exploded view of a frame strip 100 and a PCB 230, according to an embodiment. Fig. 4 illustrates PCB contacts 235 and PCB holes 237a, 237b. The opening 160a of a frame unit 110a aligns with at least one respective PCB contact 235. The frame strip 100 can allow for alignment of the openings 160a, 160b, 160c to each of the respective PCB contacts 235. Electrical coupling is possible of at least one PCB contact 235 and at least one electrical connector of the respective chicklet held by the respective opening 160a of the frame unit 110a. The PCB 230 can include holes 237a, 237b that can mate with a complementary feature of a frame unit and/or frame strip, for guiding and/or fixing the frame unit(s) 110 and/or frame strip to the PCB. For example, the fixing unit(s) 150a, 150b, 150c shown in Fig.1 can be used to guide and/or fix the frame strip 100 to the PCB 230.

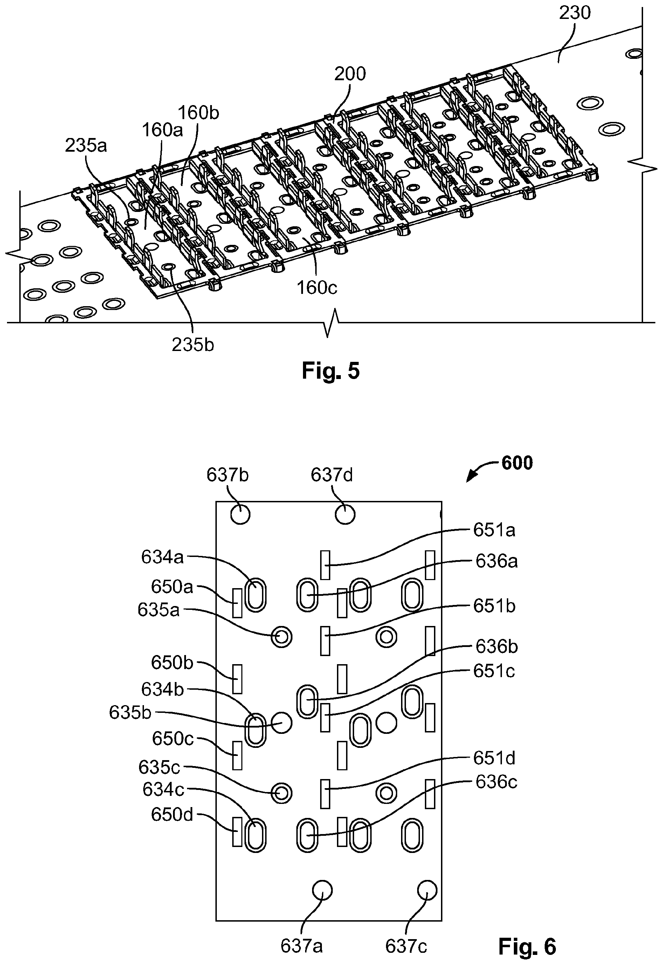

Fig. 5 shows a frame strip attached to the PCB. The respective openings 160a, 160b, 160c of each of the one or more frame units 110a, 110b, 110c of the frame strip 200 are shown. Fig. 5 illustrates, below the opening 160a, the PCB contacts 235a, 235b. When a chicklet (not shown) is held in a respective opening 160, the chicklet can make electrical contact with the PCB 230, e.g. through the PCB contacts 235a, 235b.

Fig. 6 shows a schematic of a portion of a PCB, according to an embodiment. Fig. 6 illustrates a footprint 600 corresponding to a portion of a PCB of the area of approximately two frame units, side-by-side (corresponding to the area of about two openings of each of the frame units). To ease interpretation, the features marked with reference numerals in Fig. 6 correspond to the area of the first frame unit 110a, on the right. Most of the reference numerals used in Fig. 6 refer to the features that correspond to one frame unit with one opening. Each frame unit of a frame strip can align with a complementary area of the PCB, e.g. an area that is directly under the respective opening of each frame unit for making contact with the respective chicklet held in the respective opening.

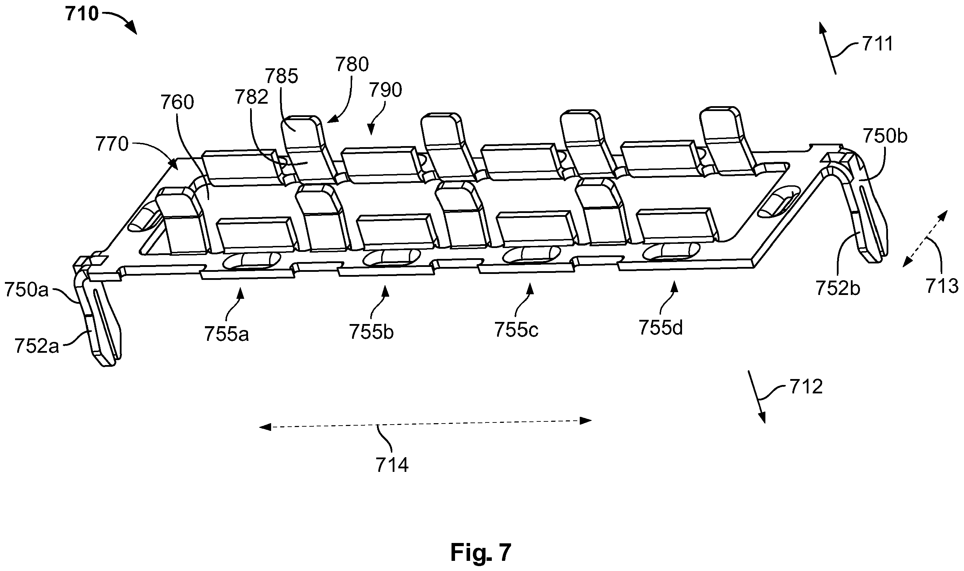

Fig. 7 shows a frame unit, according to an embodiment.

The PCB, e.g. that shown in Fig. 6, can include holes 637a, 637b, which can mate with respective guiding elements 750a, 750b of a frame unit 710 and/or frame strip, e.g. for guiding and/or fixing the frame unit and/or frame strip to the PCB. For example, each frame unit can include two fixing members (such as guiding elements 750a, 750b) at opposite corners, which may insert into corresponding holes 637a, 637b of the PCB. Fig. 6 also shows two more holes 637c, 637d for fixing a second frame unit, e.g. for fixing the second frame unit of a frame strip of at least two frame units.

Alternatively or additionally to the one or more holes 637a, 637b, the PCB may also include complementary features for connecting to features on the underside of the frame unit(s) and/or frame strip. The one or more pads 650a, 650b, 650c, 650d, 651a, 651b, 651c, 651d can align with complementary features of the frame unit 710.

For example, the frame unit and/or frame strip includes a weldable and/or solderable material, and can be welded and/or soldered to the PCB, e.g. via the pad(s). The frame unit and/or frame strip can possibly be made of stamped metal, which may reduce production costs. A monolithic frame unit and/or frame strip, for example, may reduce production costs, e.g. a stamped metal that may be coated before or after stamping (e.g. with tin). Metals, such as beryllium copper, a tin coated metal such as tin coated copper, a tin coated stainless steel, or a tin coated copper alloy such as a tin coated copper 10 alloy or a tin coated beryllium copper may be used for the frame unit and/or frame strip. A frame unit and/or frame strip of metal may also aid in making conductive contact between the frame and PCB, and the frame and the chicklet(s). Beryllium copper may be useful for resilience properties, e.g. for use as a contact spring, e.g. for holding the chicklet(s) in the respective opening(s).

The PCB contacts 635a, 635b, 635c can include those for making electrical contact with a chicklet; for example, PCB contacts 635a, 635b, 635c on the surface of the PCB make contact with complementary contacts of a chicklet. For example, one or more of PCB contacts 635a, 635b, 635c are signal contacts, e.g. for connecting to corresponding connectors of the chicklet for transmission of signals. One or more of the PCB contacts 634a, 634b, 634c, 636a, 6346, 636c may make contact with the conductive housing of the chicklet.

Each opening 160 of a frame unit 110 can be configured to align with one or more respective PCB contacts 635a, 635b, 635c, 634a, 634b, 634c, 636a, 636b, 636c for the chicklet, e.g. such that the PCB contacts 634a, 634b, 634c, 636a, 6346, 636c 635a, 635b, 635c are beneath a respective opening 160a of a frame unit 110a. The opening 160 can align form electrical coupling of at least one PCB contact and at least one electrical connector of the chicklet.

Alternatively/additionally, the opening can aid in guiding the chicklet to the corresponding electrical contacts of the PCB, particularly during assembly. Alternatively/additionally, the opening, holding the chicklet, can provide structural support to the assembly of the chicklet and PCB. The opening 160 can be configured such that electrical connections are formed between the electrical connectors of the chicklet (such connections can be direct connections) and the PCB beneath the opening 160 of the frame unit 110. The connections can be formed to the PCB directly beneath the opening. Having the connections formed directly beneath the chicklet can allow a conductive housing of the chicklet to aid in electromagnetically shielding the connections from the ambient environment. Alternatively/additionally, manufacturing can be simplified, e.g. the chicklet can be inserted into the opening and make contact with the PCB with fewer assembling operations.

The frame unit 710 has an opening 760 for holding a chicklet. The frame unit 710 can interface a chicklet and a PCB. At least one fixing member 755a, 755b, 755c, 755d can fix the frame unit 710 to a PCB. For example, the underside of the frame unit is attached to the PCB, using at least one fixing member 755a, 755b, 755c, 755d. Fixing member(s) can protrude downward toward the PCB. Fixing member(s) can be weldable and/or solderable to the PCB, e.g. through a complementary feature on the PCB, such as a pad. The fixing member(s) can form connections, such as electrical connections between the frame unit 710 and the PCB. Having multiple electrical connections can avoid EMI, ground loops, and/or provided more robust electrical connection between the frame unit 710 and PCB, and between a frame strip and the PCB.

Alternatively/additionally, at least one of the fixing member(s) 755a, 755b, 755c, 755d can act as a standoff, extending below the frame. The standoff(s) can provide a uniform distance between the frame unit and the PCB. Providing a uniform distance can aid in meeting tight mechanical and/or electrical tolerances between chicklet(s) and the PCB(s).

The opening 760 of the frame unit 710 can be surrounded by at least one edge 770 of the frame unit 710. The edge 770 can go entirely around the opening 760. The opening 760, configured to accept a chicklet, can allow the formation of electrical connections between the chicklet and the PCB beneath the frame unit (e.g. directly under the opening 760). At least part of the edge 770 of the opening 760 can make electrical contact with a chicklet, e.g. when the chicklet is held in the opening 760. An electrical contact to the chicklet can aid in shielding electromagnetic noise (EM noise), such as EM noise between connections of the PCB and chicklet.

The edge 770, or at least part of the edge 770, can flex for holding a chicklet. Alternatively/additionally, at least part of the edge 770 of the opening 760 can provide electromagnetic shielding. For example, the edge 770, or part thereof, electromagnetically shields a signal which passes through the chicklet and/or at least one PCB contact. Flexing can aid in holding the chicklet without damage and/or can aid in making a low resistance electrical connection.

Fig. 7 shows a contact spring 780 at the edge 770 of the opening 760 of a frame unit 710. The contact spring(s) 780 can hold a chicklet and/or make electrical contact to the chicklet. Such functions can aid in allowing the assembling process to meet strict electrical and/or mechanical tolerances for making connections between the chicklet and the PCB. The contact spring(s) 780 can be more compliant than the chicklet. Flexing can aid in holding the chicklet without damage and/or can aid in making a low resistance electrical connection.

The contact spring(s) 780 can extend above the edge 770 of the opening. Herein, "above," or the upwards direction 713 is away from the direction toward the PCB, which is the downward direction 712. The bottom of the frame unit 710 can connect to the PCB. The contact spring(s) 780 can extend above 711 the edge 770 of the opening 760, and the guiding element(s) 750a, 750b can extend in the downward direction 712. The contact springs(s) 780 may have an upper portion 785 and lower portion 782. The portions 785, 782 may form different angles with respect to the plane of the opening and/or surface of the chicklet. The chicklet can be held by contact forces from the edge 770 and/or contact springs (780) at the edge 770 of the opening 760, which can include above the edge 770 of the opening 760.

At least one of the upper or lower portions 785, 782 of the contact spring(s) 780 can extend at an angle toward a spatial region directly above the opening 760. The angle of the upper or lower portion 785, 782 can be nonperpendicular with the plane of the PCB and/or plane of the opening. The other of the portions 785, 782 can provide a surface that is approximately perpendicular to the opening 760, which can make good contact with the chicklet.

At least the angled portion of the contact spring(s) 780 can extend into a spatial region directly above the opening, such as when a chicklet is absent. For example, the lower portion 782 is angled such that the lower portion 782 extends into the spatial region directly above the opening 760 when the chicklet is absent; when the chicklet is held in the opening 760, the lower portion 782 can flex away from the opening 760, and/or the upper portion 785 can make surface to surface contact with the chicklet. The flexing can provided an adequate contact force for holding the chicklet in the opening 760, e.g. along the edge 770. When the chiclet is held, the contact spring 760 can extend directly upward, and make contact with the chicklet directly above and/or even with the edge 770 of the opening 760.

Fig. 7 also shows shielding element(s) 790. A frame unit 710 can include shielding element(s) 790. The shielding element(s) can extend above the bottom of the edge 770 of the opening 760, e.g. directly upward 711. Shielding elements 790 may be shaped to fill in, at least partially, the space between contact springs 780, e.g. along the edge 770. The shielding element(s) 790 can reduce electromagnetic interference of signals in the chicklet and/or PCB. Shielding elements 790, such as those shown in Fig. 7, can extend above the opening 760. As depicted in Fig. 7, the contact spring(s) 780 can extend to a height above that of the shielding element(s) 790. Shielding element(s) 790 can have a surface extends parallel to the surface of the chicklet. Alternatively/additionally, the nearest surface of the shielding element(s) 790 to the chicklet is perpendicular to the opening 760.

The upper portion 785 of the contact spring, can aid in guiding the chicklet into the opening 760 during assembly of a device. The upper portion 785 of the contact spring can extend farther above the plane of the opening 760 than the shielding element(s) 790, e.g. to aid in guiding the insertion of the chicklet into the opening and/or to aid in guiding toward the forming of connections between the chicklet and the PCB.

The lower portion(s) 782 and/or upper portions 785 of the contact springs 780 can possibly aid in electromagnetic shielding, such as in combination with the shielding element(s) 790.

The opening 760 can have a long axis 714 and a short axis 713. Contact spring(s) 780 and/or shielding element(s) 790 can be along the long axis 714 of the opening 760. Contact spring(s) 780 and/or shielding element(s) 790 can be positioned on either side of the opening 760 along respective opposite edges 770 of the opening 760. Contact springs can be positioned directly opposite shielding elements 790, across the opening 760 from each other. Such an alternating arrangement of contact springs 780 and shielding elements 790 can more evenly distribute stress from the contact force of the springs and aid in longevity of the electrical and mechanical connections.

The guiding elements 750a, 750b can be inserted into holes of the PCB, for example to aid in alignment of the opening 760 to the PCB contacts. Alternatively/additionally, the guiding elements 750a, 750b may include features to aid in fixing the frame unit 710 firmly to the PCB, such as chamfered surfaces 752a, 752b.

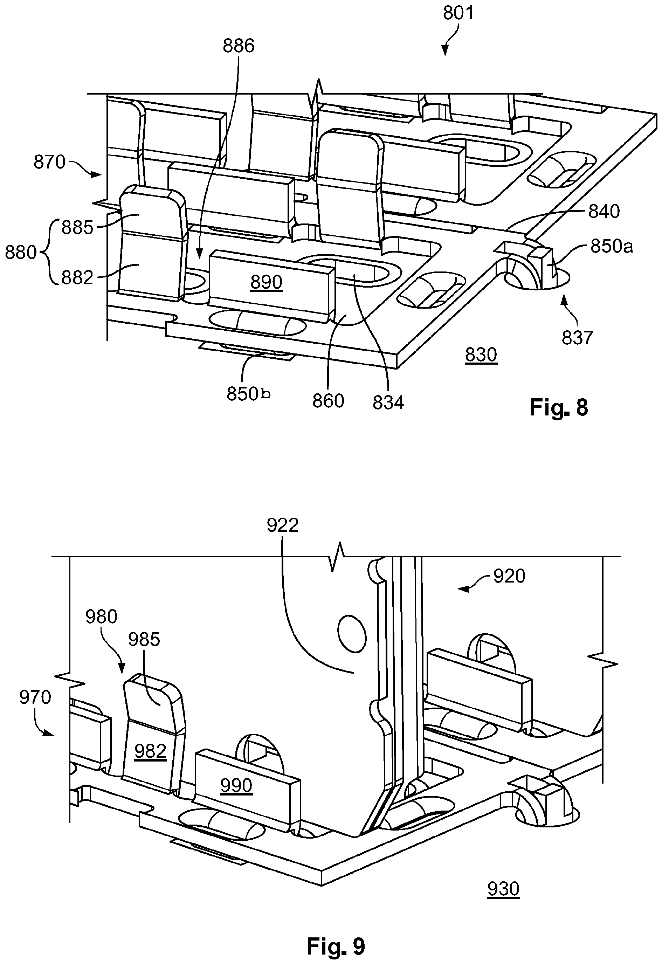

Fig. 8 shows a portion of a frame strip on a PCB, according to an embodiment. The portion shown in Fig. 8 can be illustrative of any frame strip described herein. The frame units (e.g. of the frame strips described herein) can include fixing member(s) 150, such as guiding elements 850a and/or standoffs 850b.

To aid in understanding, Fig. 8 shows a hole 837 of a PCB 830. A guiding element 850a of a frame strip 801 (a portion of which is shown in Fig. 8) is inserted in the hole 837.

Fig. 8 also shows a standoff 850b of the frame strip 801 which can extend below the frame strip 801. The standoff 850b can be soldered and/or welded to the PCB, such as to a pad of the PCB. The standoff(s) can provide a uniform distance between the frame unit and/or frame strip and the PCB. Alternatively/additionally, the standoffs can provide a flat orientation of the opening(s) 160 of the frame unit and/or frame strip 801, e.g. parallel to the plane of the PCB. Having a planar fixed orientation of the frame unit and/or frame strip 801 can aid in attaching the chicklets, in view of the connections between the PCB and chicklet(s) having possibly tight physical and/or electrical tolerances.

The frame strip 801 of Fig. 8 has portions of two openings viewable, in which a PCB contact 834 is referenced. The PCB contact(s) 834 can make contact with a chicklet; e.g. the terminal(s), pin(s), and/or housing of a chicklet.

Fig. 8 shows a groove 840 which can optionally be used to separate one or more frame units from a frame strip. When assembling devices, it can be convenient to use a strip of frame units (herein, a frame strip) so that one or more frame units can be interfaced to the PCB at a time, the chicklet(s) being subsequently inserted into each of the respective opening(s) of the frame units and connected to the PCB. The frame strip can include a plurality of connected frame units (which can be separable, e.g. along respective grooves 840).

Fig. 8 shows shielding elements 890 and spring contacts 880 (having the optional upper and lower portions 885, 882) along an edge 870 of the opening 860. There can be a gap 886 between adjacent shielding elements and spring contacts. There is a gap (885), for example, between nearest neighbour shielding elements and contact springs, the gap being along the long axis of the edge of the opening and/or the opening.

There can be at least one gap 886 along an edge 870 of the opening, between the neighboring lower portion 885 of a spring contact 880 and a respective neighboring shielding element 890. The gap 886 can allow for flexing of the spring contacts 880, e.g. so that the spring contacts 880 can require a reduced force for insertion of the chicklet into the opening. A reduced force can minimize the risk of breakage, such as during assembly, such as cracking of the PCB. Gaps can be along the long axis of the respective edges 770, e.g. allowing even distribution of the contact force of the contact springs on the respective chicklets.

Fig. 9 illustrates a portion of a frame strip on a PCB and a chicklet. The portion of the frame strip shown, and the illustrated interaction with the chicklet 920 shown in Fig. 9 can be illustrative of any frame strip described herein. A chicklet 920 can be held in a respective opening of a frame unit, e.g. of a frame strip. Each opening can hold one chiclet, e.g. via a contact force of the edge of a respective opening of the respective frame unit with a surface(s) of the held chicklet. Fig. 9 shows the edge 970 of the opening which may flex for holding the chicklet 920. The edge 970, or part thereof, that flexes may do so reversibly, e.g. so that a contact force arises between the edge 970, or part thereof, and the chicklet 920 and/or surface 922 therof.

Fig. 9 illustrates electrical and/or physical contact between the contact spring 980 and the chicklet 980. For example, there is contact between a lateral surface 922 of the chicklet 920 and the contact spring 980, such as the top portion 985 of the contact spring 980. The bottom of the chicklet 920 can make mechanical and/or electrical contact to the PCB, such as directly below the opening of the frame unit.

The bottom portion 982 of the contact spring 980 may be angled toward the chicklet 920. The optional shielding element 990 may also make electrical and/or physical contact with the chicklet, e.g. by contact between respective surfaces thereof, including the lateral surface 922 of the chicklet 980. Contact between the chicklet 920 (and/or surface 922 thereof) can occur along the edge 970 of the opening, e.g. along the long axis 714 thereof. The chicklet can make an electrical and/or physical connection(s) to the PCB 930; for example, the connection(s) is made to the PCB directly beneath the opening, e.g. with no intervening material or feature between the surface of the PCB beneath the chicklet and the chicklet other than, optionally, solder, solder paste, solder flux, and/or flux.

The edge 970 of the opening (which may have two opposing long edges and two opposing short edges) of the frame unit can abut the chicklet 920 on the two opposite lateral sides of the chicklet 920, along a long edge of the opening 970. Additionally, the top of the frame unit at the narrow edge(s) of the opening may abut the bottom of the chicklet 920 at a short edge of the chicklet. The edge (970) of the opening can include the contact spring(s) (980) and/or shield element(s) (990).

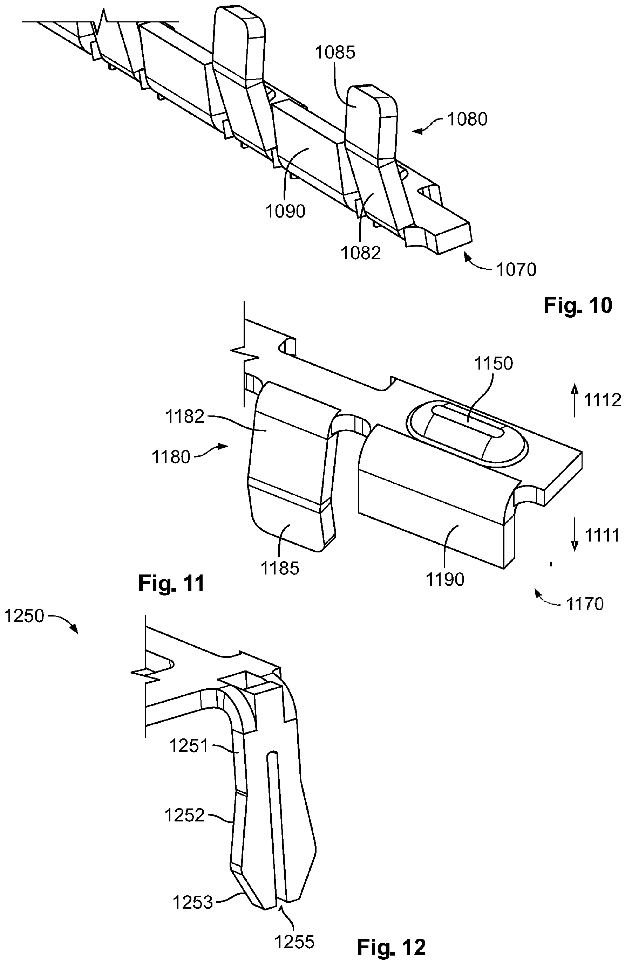

Fig.10 illustrates a portion of an edge 1070 of a frame unit. The portion of the frame unit shown in Fig. 10 can be illustrative of any frame strip described herein. The edge 1070 can have spring contacts 1080 and/or shielding elements 1090 along a length thereof, e.g. the long axis thereof. Spring contact(s) 1080 can include upper portions 1085 and lower portions 1082. Shielding elements 1090 can have a contact surface configured to make contact with the lateral surface 922 of a chicklet. Alternatively/additionally, upper portions 1085 of spring contact(s) 1080 can have surfaces for making direct contact with a chicklet and/or surface (such as lateral surfaces) thereof.

Fig. 11 illustrates a view of a portion of an edge 1170 of a frame unit. The portion of the frame unit shown in Fig. 11 can be illustrative of any frame strip described herein. The bottom of a portion of a frame unit is shown. The downward direction 1112, toward the PCB is indicated, as is the upward direction 1111. The edge 1117 can include the shielding element(s) 1190 and/or the contact spring(s) 1180. The bottom of the frame unit portion shows a type of fixing member 150, for fixing the frame unit and/or frame strip to a PCB. Fixing members can be for mechanical attachment (mechanical connection) and/or electrical connection.

Fixing members 150 of the frame units and/or frame strips described herein can include standoffs 1150, such as that shown in Fig. 11. One or more standoffs 1150 can extend below the frame unit and/or frame strip. The standoffs can be solderable and/or weldable to form connections (such as electrical connections to the PCB). Standoffs can provide a uniform distance between the frame unit and PCB; altematively/additionally, standoffs can provide uniform distance between the frame strip and PCB.

Fig. 12 shows a guiding element, according to an embodiment. The guiding element 1250 can be part of any frame unit and/or frame strip described herein. The guiding element 1250 can be insertable in a hole of the PCB, and may serve to guide attachment of the frame unit and/or strip to the PCB. The guiding element 1250 extends in a direction below the frame unit. The guiding element can include at least one chamfered edge, such as edge 1252 which can make frictional contact with the hole of the PCB, and may aid in fixing the frame unit to the PCB. The guiding element 150 can include a slot 1255 or the like, so that a radial dimension of the guiding element 1250 can be reversibly reduced, e.g. during insertion into the hole.

The tip of the guiding element may have a cross sectional area that increases, going from the bottom of the guiding element 1250 upward, to a position of maximum cross-sectional area. Above the position of the maximum cross-sectional area, the guiding element may decrease in cross-sectional area. The decrease may take the form of a chamfered edge 1252, such as that shown in Fig. 12.

The chamfered edge 1252 may be sized to press outwardly against the hole of the PCB to aid in fixing the frame unit and/or frame strip to the PCB. There may additionally be a shank portion 1251, which may aid in ensuring a uniform distance between the PCB and the frame unit and/or frame strip. At least two of the chamfered edge 1252, shank portion 1251, and standoffs 1150 described herein may work synergistically to ensure a uniform distance between the PCB and the frame unit(s). The standoffs 1150 can be sized, in synergy with the size of the shank portion 1251 and size and angle of the chamfered edge 1252, to provide a holding force to hold the PCB against the underside of the frame unit and/or frame strip.

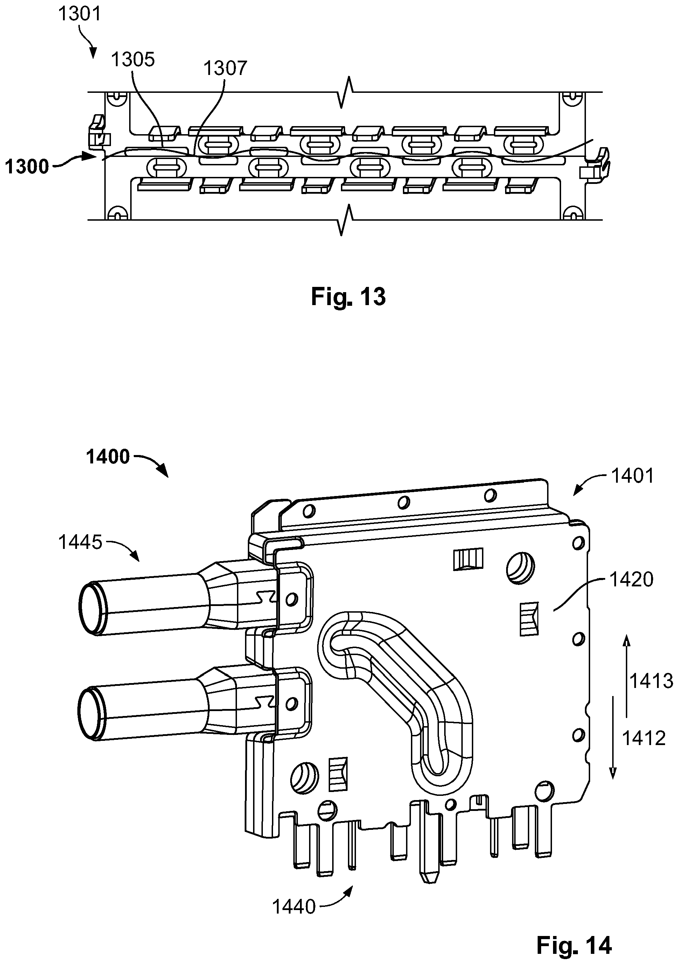

Fig. 13 shows a groove between two adjacent frame units. A groove can be part of any frame strip described herein. Fig. 13 shows only portions of the frame units 1301. A groove 1300 may be positioned at the border between two adjacent frame units 1301, e.g. between adjacent frame units of a frame strip. The groove 1300 may allow for easy separation of a frame unit from an adjacent frame unit or from the remainder of a frame strip. Alternatively, the groove 1300 may allow for separation of a plurality of frame units from the remainder of the frame strip. For ease of reconfigurable manufacturing, it is convenient to be able to separate any number of frame units from a frame strip, e.g. depending on the desired number of chicklets to attach to the PCB.

The groove 1300 can have a long axis which is in alignment with the long axis of the openings of the adjacent frame units. The groove 1300 can include through holes 1305 (e.g. in the form of slots that may extend with their long axes along the long axis of the groove 1300). Alternatively/additionally, the groove 1300 can include a partial cut 1307 into the material of the frame strip, e.g. along an outer edge of a frame unit. A groove 1300 can include portions that go through the frame strip 1301, e.g. slots and portions that form a trench or partial cut 1307 in the frame strip 1301.

The inner edge of the opening of a frame unit can be configured to hold a chicklet, and the outer edge may be the position of the groove 1300, where a separation can be done from an adjacent frame unit.

A frame strip can include a groove 1300 between two adjoining frame units, configured for separation of the two adjoining frame units. The groove can extend in the direction of the long axes of the openings of the frame units. The groove can include at least one through-hole and/or at least one depression, e.g. the partial cut described above.

Fig. 14 shows a chicklet. The frame units described herein can hold a chicklet such as that of Fig. 14. The upward direction 1413 and downward 1412 directions are shown. A chicklet can have a metal housing which can be a rigid housing 1401, e.g. more rigid than a plastic housing. The chicklet can have one or more connectors 1440 configured to interface with a PCB, such as directly to a PCB, e.g. on the bottom. The frame units described herein are configured to facilitate connection between chicklets 1400 on the bottom face to the PCB. The lateral surfaces 1420 of chicklets can be metal. The housing of the chicklets can be metal. Metal can aid in EMI shielding. Additional connectors 1445 may connect to other devices, such as another PCB, a surface mounted device, and/or another connector assembly. The additional connectors 1445 can protrude from a narrow lateral face. Narrow lateral face(s) connect the larger lateral faces configured to accept contact forces from the edges of the openings of frame units and//or contact springs.

The lateral surface 1420 for accepting the contact for is, for example, the largest side of a generally rectangular prismatic shape of the chicklet 1400. The frame units described herein can be configured to apply a contact force to the lateral face(s) 1420 of a held chicklet 1400, particularly the opposite lateral faces.

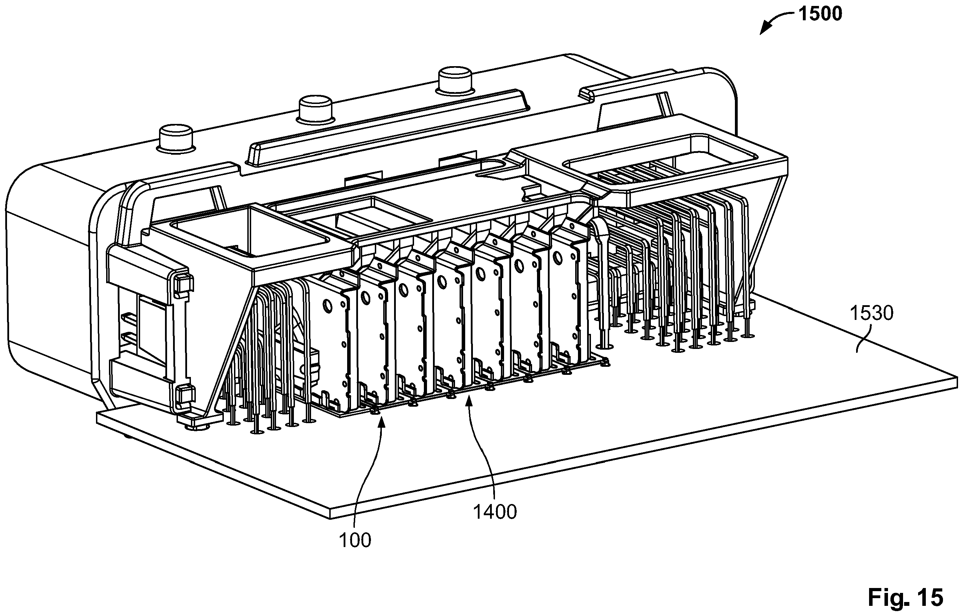

The chicklet is configured to make contact with the PCB by the bottom face thereof (the face of the chicklet that faces the PCB). For example, the two lateral faces 1420 (the second is in the rear of Fig.15) of the chicklet 1400 are held by the openings of the frame unit (such as the edge(s) thereof) and/or the contact springs. Between the lateral faces 1420 of the chicklet 1400, conductive elements may connect the connectors 1440 at the bottom of the chicklet to the additional connectors 1445 at one of the narrow lateral faces. The lateral faces 1420 can provide EM shielding. Lateral faces made of metal may be contacted by conductive features of the frame units, e.g. edge(s) of the opening and/or contact springs.

Fig. 15 shows a connection assembly, according to an embodiment. The connection assembly 1500 can include a PCB 1530, at least one chicklet 1400, at least one frame unit 110 that holds the at least one chicklet. The frame unit 110 can be according to any frame unit described herein, and, moreover, can be part of any frame strip described herein.

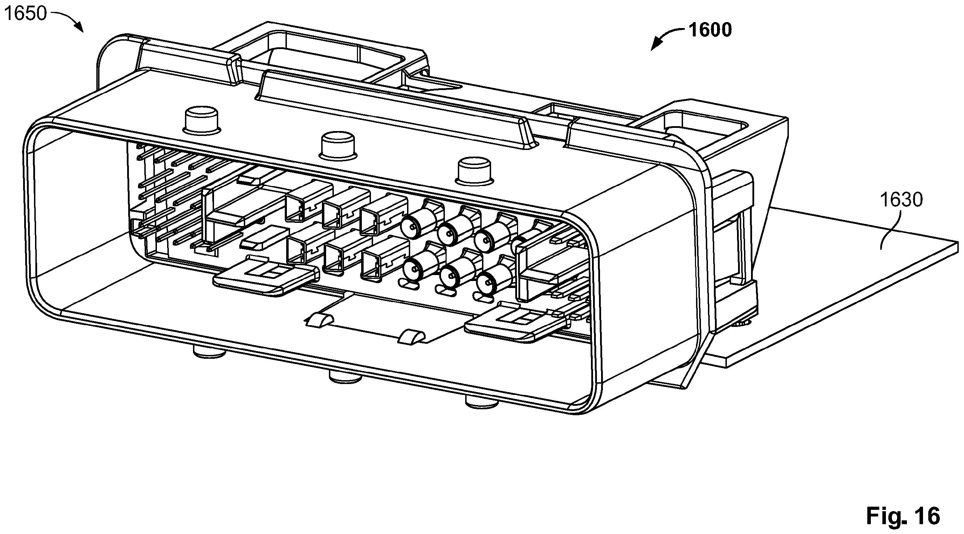

Fig. 16 illustrates a connector assembly. A connector assembly 1600 can include a PCB 1630; at least one chicklet 1400 electrically connected to at least one PCB contact of the PCB 1630. Each chicklet can be held by a respective frame unit (e.g. any frame unit described herein), such as a frame unit of a frame strip (e.g. any frame strip described herein).

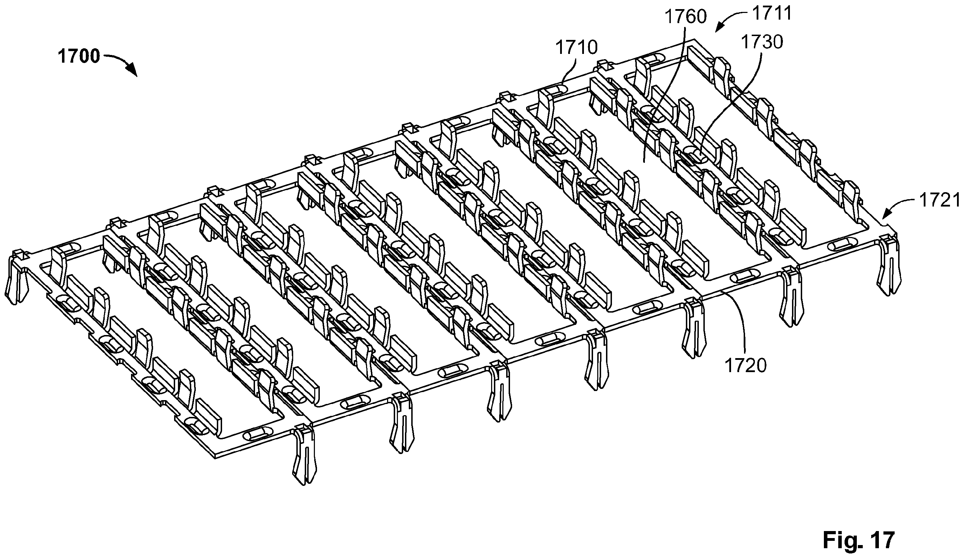

Fig. 17 illustrates a frame strip, according to an embodiment. The features described with respect to the frame strip 1700 of Fig. 17 can be part of any frame strip described herein. The frame strip 1700 includes an opening 1760, such as an opening of any frame unit described herein. The frame strip 1700 can include a first rail 1710 and a second rail 1720 which are at opposite edges 1711 and 1721 of the respective openings 1760 of the frame units. The frame strip 1700 can include a plurality of frame members 1760 which connect the first and second rails 1710, 1720, the frame members being along a long axis of the respective openings 1760. Each of the frame members 1760 can include edges for holding the chicklet, and optionally the groove described herein. The frame strip 1700 can include a plurality of frame units, the frame units being as described herein. The frame member 1760 can include the edges, as described herein (including possibly the spring contacts and/or shield members), of the openings of the frame units.

Herein, a frame unit can be about 15 to 35 mm in the long direction, and 4 to 8 mm in the short direction. Herein, an opening of a frame unit can have a length along the long axis of 10 to 30 mm; and a length along the short axis of 2 to 5 mm. Herein, the frame members of frame strips can have a width (in the direction of the short axis of the openings) of 2 to 6 mm, such as 3 to 5 mm. Herein, the rails of frame strips can have a width (in the direction of the long axis of the openings) of 3 to 10 mm, or 4 to 8 mm, such as about 5 to 6 mm.

Herein, the contact springs can be conductive, e.g. for forming an electrical connection to the chicklet.

Herein, "*and*/*or*" and "/" mean "*and*" or "or," for example, "*weldable* and/or solderable" means only weldable, only solderable, or both weldable and solderable. "Weldable and/or solderable" can also be expressed as "weldable/solderable."

Herein, "*above*" can mean reaching a point higher than a reference point, e.g. reaching a position farther away from the PCB in a direction perpendicular to the PCB surface. Herein, "*directly above*" can mean reaching a point higher than a reference point along a line, e.g. "*directly above the opening*" can mean reaching a position along a line that is perpendicular to both the opening and the PCB, and on the opposite side of the opening as the PCB.

Herein, the direction above a frame unit and/or frame strip is the direction perpendicular to the plane of the opening of the frame unit and/or frame strip. Herein, the direction below a frame unit and/or frame strip is the direction perpendicular to the plane of the opening of the frame unit and/or frame strip.

The chicklets described herein can include a metal housing, such as a rigid metal housing. Rigid metal housings can provide good electromagnetic shielding, particularly in comparison to plastic housings of similar size. Herein, a chicklet can be a contact module for connecting electrical components, such as for connecting the PCB to other connectors, particularly those of surface mounted devices (SMDs).

Herein a chicklet can be an electrical connector with a rigid metal housing. A chicklet can be for connecting high frequency signal lines, such as between a PCB and another PCB, or between a PCB and a surface mounted device. Herein, the guiding elements described can be considered board locks, e.g. for locking the frame unit(s) to the PCB.

Rigid housings, particularly those of chicklets, can have lower tolerances than more flexible housings, such as for alignment to the PCB, such as alignment to complementary attachment structures of the PCB, and/or such as alignment to complementary electrical connectors of the PCB. Demands of high tolerances can affect the error rate of manufacturing. The frame units and/or frame strips described herein can reduce the manufacturing error rate, e.g. by providing a mechanism to meet demanding electrical and/or mechanical connection tolerances.

In the following, a list of reference numerals used herein is given, which is not intended to be limiting, as are the examples provided herein, which are for explanation.

### REFERENCE NUMERALS

- 100: frame strip
- 110a, 110b, 110c: frame unit
- 150a, 150b, 150c: fixing member
- 160a, 160b, 160c: opening
- 170a, 170b, 170c: edge of opening
- 200: frame strip
- 201: frame strip
- 220: chicklets
- 222: chicklets
- 230: PCB
- 235a, b: PCB contacts
- 237a, b: PCB hole
- 600: footprint
- 634a, b, c: PCB contacts to housing
- 635a, b, c: PCB contacts
- 636a, b, c: PCB contacts to housing
- 637a, b: PCB holes
- 650: complementary fixing member on PCB (pad for standoffs)
- 651a, b, c,: complementary fixing member on PCB
- 710: frame unit
- 711: above
- 712: below
- 713: short axis
- 714: long axis
- 750a, b: guiding element
- 752a, b: chamfered edge
- 755a, b, c, d: fixing member
- 760: opening
- 770: edge
- 780: contact spring
- 790: shielding element
- 801: partial frame strip
- 830: PCB
- 837: PCB hole
- 840: groove
- 850a: guiding element
- 850b: standoff
- 860: opening
- 870: edge
- 880: spring contact
- 882: lower portion
- 885: upper portion
- 886: gap
- 890: shielding element
- 920: chicklet
- 922: surface
- 930: PCB
- 970: edge
- 980: contact spring
- 982: lower portion
- 985: upper portion
- 990: shielding element
- 1070: edge
- 1080: contact spring
- 1082: lower portion
- 1085: upper portion
- 1090: shield element
- 1111: up
- 1112: down
- 1150: standoff
- 1170: edge
- 1180: contact spring
- 1182: lower portion
- 1185: upper portion
- 1190: shielding element
- 1250: guiding element
- 1251: shank
- 1252: chamfer
- 1253: chamfer
- 1255: slot
- 1300: groove
- 1301: adjacent frame units
- 1305: through hole
- 1307: partial cut
- 1400: chicklet
- 1401: housing
- 1412: down
- 1413: up
- 1420: lateral surface
- 1440: connectors
- 1445: additional connectors
- 1500: connector assembly
- 1530: PCB
- 1600: connector assembly
- 1630: PCB
- 1650: plug
- 1700: frame strip
- 1710: first rail
- 1711: first edge
- 1720: second rail
- 1721: second edge
- 1730: frame member
- 1760: opening

## Claims

1. A frame unit (110, 710) configured to interface a chicklet (220) and a printed circuit board (230), PCB, comprising:
at least one fixing member (150) configured to fix the frame unit to the PCB (230);
an opening (160, 760) configured to accept a chicklet (220), and configured such that electrical connections are formed between the chicklet and the PCB beneath the frame unit (110, 710); wherein
the opening is configured to hold therein the chicklet.

2. The frame unit (110, 710) of claim 1, wherein
the frame unit (110) is configured to make conductive electrical contact with the chicklet (220); optionally at least part of an edge (170, 770) of the opening (160) is configured to make conductive electrical contact with the chicklet.

3. The frame unit (110, 710) of claim 1 or 2, wherein
the opening (160) is configured to align with at least one PCB contact (235a, 235b) for electrical coupling of the at least one PCB contact and at least one electrical connector (225) of the chicklet (220); and/or
the opening (160) is configured such that electrical connections are formed between the electrical connectors (225) and the PCB (230) beneath the opening (160) of the frame unit (110).

4. The frame unit (110, 710) of claim 3, wherein
at least part of an edge (170) of the opening (160, 760) is configured to flex for holding the chicklet (220); and/or
at least part of the edge (170) of the opening (160) is configured to electromagnetically shield a signal which passes through the chicklet and/or the at least one PCB contact (235).

5. The frame unit (110, 710) of claim 4, further comprising
at least one contact spring (780) at the edge (170, 770) of the opening for holding the chicklet (220) and/or for making electrical contact to the chicklet.

6. The frame unit (110, 710) of claim 5, further comprising
at least one shielding element (790) that extends above the bottom of the edge (170, 770) of the opening (160, 760); wherein the at least one contact spring (780) extends above the at least one shielding element (790); wherein optionally
the at least contact spring (780) is a plurality of contact springs and the at least one shielding element is a plurality of shielding elements, and optionally the contact springs and shielding elements alternate positions along the edge (170, 770).

7. The frame unit (110, 710) of claim 5 or 6, wherein
the opening (160, 760) has a short axis (713) and a long axis (714), and the contact springs (780) are along the long axis.

8. The frame unit (110, 710) of any one of claims 1 to 7, wherein
the at least one fixing member (150) includes
one or more standoffs (850b) which extends below the frame unit (110, 710), wherein the one or more standoffs is optionally solderable or weldable to form connections, such as electrical connections to the PCB (230); wherein optionally
the one or more standoffs (850b) are configured to provide a uniform distance between the frame unit (110, 710) and the PCB (230).

9. The frame unit (110, 710) of any one of claims 1 to 8, wherein
the at least one fixing member (150) includes
a guiding element (750) extending below the frame unit, the guiding element configured to mate with a hole (237, 637f) of the PCB (230); wherein optionally
the guiding element includes at least one chamfered edge (752) configured to make contact with the hole of the PCB (230) for fixing the frame unit to the PCB.

10. The frame unit (110, 710) of any one of claims 1 to 9, wherein
the frame unit comprises a solderable and/or weldable material; optionally wherein the material includes at least one of beryllium copper, a tin coated metal such as tin coated copper, a tin coated stainless steel, or a tin coated copper alloy such as a tin coated copper 10 alloy or a tin coated beryllium copper.

11. A frame strip (100, 200, 201, 1700), comprising
a plurality of connected frame units (110, 710), each frame unit according to of any one of claims 1 to 10.

12. The frame strip (100, 200, 201, 1700) according to claim 11, further comprising
a groove (1300) between two adjoining frame units (110, 710, 1301), configured for separation of the two adjoining frame units.

13. The frame strip (100, 200, 201, 1700) according to claim 11 or 12, further comprising:
a first rail (1710) and a second rail (1720) which are at opposite edges (1711, 1721) of the respective openings (160, 760, 1760) of the frame units (110, 710); and
a plurality of frame members (1730) which connect the first and second rails, the frame members being along a long axis (714) of the respective openings.

14. The frame strip (100, 200, 201, 1700) according to claim 13, wherein
the at least one fixing member (150) extends below at least one of
the first rail (1710), the second rail (1720), or the frame members (1730); and wherein
the at least one contact spring (780) and/or the at least one shielding element (790) extend above the frame members (1730).

15. A connection assembly comprising
a PCB (230);
at least one chicklet (220) electrically connected to at least one PCB contact (235, 634, 635, 636) of the PCB and held by at least one respective frame unit (110, 710) of any one of claims 1 to 11.
